# EUROPEAN PATENT APPLICATION

(11) **EP 4 625 750 A1**
(43) Date of publication of application: **01.10.2025**
(21) Application number: 23908999.8
(22) Date of filing: 31.05.2023
(51) Int. Cl.: H02J 7/00, H02J 15/00

(54) **METHOD AND APPARATUS FOR DETERMINING PROTECTION POLICY FOR ENERGY STORAGE SYSTEM, AND RELATED DEVICE**

(30) Priority: 27.12.2022 CN 202223530041 U; 27.12.2022 CN 202211683637
(71) Applicant: Eve Energy Storage Co., Ltd, Wuhan, Hubei 430074 (CN)
(72) Inventor: SI, Wei, Wuhan, Hubei 430074 (CN); LIU, Shilei, Wuhan, Hubei 430074 (CN); MENG, Yubao, Wuhan, Hubei 430074 (CN); SHUAI, Changjun, Wuhan, Hubei 430074 (CN)
(74) Representative: Berggren Oy
(86) International application number: PCT/CN2023/097626
(87) International publication number: WO 2024/139052

(57) **Abstract**

The present disclosure provides a method and apparatus for determining a protection strategy for an energy storage system and a device related thereto. The method compares first target posture sensing data, first target tilt sensing data, and first target seismic sensing data respectively obtained in advance when the energy storage system is in an operation state with a preset posture sensing threshold, a preset tilt sensing threshold, and a preset seismic sensing threshold, respectively, to determine a first target protection strategy configured to protect the energy storage system based on a plurality of comparison results.

## Description

This application claims priorities to Chinese Patent Applications No. 202211683637.6, titled "METHOD AND APPARATUS FOR DETERMINING PROTECTION STRATEGY FOR ENERGY STORAGE SYSTEM, AND DEVICE RELATED THERETO" and No. 202223530041.0, titled "Energy storage management and protection system", filed with the Chinese Patent Office on December 27, 2022, contents of both of which are incorporated herein by reference in their entireties.

### TECHNICAL FIELD

The present disclosure relates to the field of energy storage systems, and more particular to a method and apparatus for determining a protection strategy for an energy storage system, and a device related thereto.

### BACKGROUND

An energy storage system is a part of an object or a space range delineated for determining a subject of study when an energy storage process is analyzed, and includes input and output devices of energy and a substance, and energy conversion, and storage devices. The energy storage system often involves multiple energies, multiple devices, multiple substances, multiple processes, and is a complex energy system that varies over time, requiring multiple evaluation indexes to describe its performance. Commonly used evaluation indexes include energy storage density, energy storage power, energy storage efficiency, energy storage price, environmental impact and so on.

### SUMMARY

The present disclosure provides a method and apparatus for determining a protection strategy for an energy storage system, and a device related thereto to solve a problem of how to enable an energy storage system to actively cope with a ground fluctuating and bumping state (such as that caused by an earthquake or other factors) and the like that endangers the safety of the energy storage system.

To this end, the present disclosure provides following technical solutions.

In a first aspect, the present disclosure provides a method for determining a protection strategy for an energy storage system, including:
receiving a plurality of pieces of sensing data transmitted by a preset sensing system when the energy storage system is in an operation state, the plurality of pieces of sensing data including posture sensing data, tilt sensing data, and seismic sensing data;
normalizing the posture sensing data, the tilt sensing data, and the seismic sensing data, respectively, to obtain first target posture sensing data, first target tilt sensing data, and first target seismic sensing data;
comparing the first target posture sensing data with a preset posture sensing threshold to obtain a first comparison result, comparing the first target tilt sensing data with a preset tilt sensing threshold to obtain a second comparison result, and comparing the first target seismic sensing data with a preset seismic sensing threshold to obtain a third comparison result; and
determining a first target protection strategy configured to protect the energy storage system based on the first comparison result, the second comparison result, and the third comparison result.

In a second aspect, the present disclosure provides an apparatus for determining a protection strategy for an energy storage system, including:
a first receiving unit configured to receive a plurality of pieces of sensing data transmitted by a preset sensing system when the energy storage system is in an operation state, the plurality of pieces of sensing data including posture sensing data, tilt sensing data, and seismic sensing data;
a first normalization unit configured to normalize the posture sensing data, the tilt sensing data, and the seismic sensing data, respectively, to obtain first target posture sensing data, first target tilt sensing data, and first target seismic sensing data;
a first comparison unit configured to compare the first target posture sensing data with a preset posture sensing threshold to obtain a first comparison result, a second comparison unit configured to compare the first target tilt sensing data with a preset tilt sensing threshold to obtain a second comparison result, and a third comparison unit configured to compare the first target seismic sensing data with a preset seismic sensing threshold to obtain a third comparison result; and
a first determining unit configured to determine a first target protection strategy configured to protect the energy storage system based on the first comparison result, the second comparison result, and the third comparison result.

**In** a third aspect, the present disclosure further provides an electronic device, including:
one or more processors;
a memory; and
one or more application programs, where the one or more application programs are stored in the memory and configured to be executed by the processors to implement the method for determining the protection strategy for the energy storage system.

In a fourth aspect, the present disclosure further provides a computer readable storage medium having stored thereon a computer program that is loaded by a processor to perform steps of the method for determining the protection strategy for the energy storage system.

In a fifth aspect, the present disclosure further provides an energy storage management and protection system, including:
an energy storage unit;
a sensor system including at least a posture sensor, a tilt sensor, and a seismic sensor and configured to acquire a plurality of pieces of sensing data of the energy storage unit in an operation state; and
a processor electrically connected to the energy storage unit and the sensor system, respectively, the processor being configured to receive the plurality of pieces of sensing data transmitted by the sensor system, determine a target protection policy for protecting the energy storage unit, and control the operation state of the energy storage unit based on the target protection policy.

### Beneficial Effects

Beneficial Effects of the present disclosure are that:
the method for determining the protection strategy for the energy storage system provided in the present disclosure receives a plurality of pieces of sensing data transmitted by a preset sensing system when the energy storage system is in an operation state, the plurality of pieces of sensing data including posture sensing data, tilt sensing data, and seismic sensing data; normalizes the posture sensing data, the tilt sensing data, and the seismic sensing data, respectively, to obtain first target posture sensing data, first target tilt sensing data, and first target seismic sensing data; compares the first target posture sensing data with a preset posture sensing threshold to obtain a first comparison result, compares the first target tilt sensing data with a preset tilt sensing threshold to obtain a second comparison result, and compares the first target seismic sensing data with a preset seismic sensing threshold to obtain a third comparison result; and determines a first target protection strategy configured to protect the energy storage system based on the first comparison result, the second comparison result, and the third comparison result. It is possible to enable the energy storage system to actively cope with the ground fluctuating and bumping state (such as that caused by the earthquake or other factors) and the like that endangers the safety of the energy storage system, thereby improving the safety of the energy storage system.

### DESCRIPTION OF THE DRAWINGS

FIG. 1 is a schematic diagram of a scenario of a system for determining a protection strategy for an energy storage system according to an embodiment of the present disclosure.
FIG. 2 is a schematic flowchart of an embodiment of a method for determining a protection strategy for an energy storage system according to an embodiment of the present disclosure.
FIG. 3 is a schematic structural diagram of an embodiment of an apparatus for determining a protection strategy for an energy storage system according to an embodiment of the present disclosure.
FIG. 4 is a schematic structural diagram of an embodiment of an electronic device according to an embodiment of the present disclosure.
FIG. 5 is a schematic structural diagram of an energy storage management and protection system according to an embodiment of the present disclosure.
FIG. 6 is a schematic structural diagram of a sensor system according to an embodiment of the present disclosure.
FIG. 7 is another schematic structural diagram of a sensor system according to an embodiment of the present disclosure.
FIG. 8 is yet another schematic structural diagram of a sensor system according to an embodiment of the present disclosure.
FIG. 9 is a schematic structural diagram of a fire fighting unit according to an embodiment of the present disclosure.

### DETAILED DESCRIPTION

Technical solutions in embodiments of the present disclosure will be clearly and completely described below in conjunction with drawings in the embodiments of the present disclosure. Obviously, the described embodiments are only a part of embodiments of the present disclosure, rather than all the embodiments. Based on the embodiments in the present disclosure, all other embodiments obtained by those skilled in the art without creative work fall within the protection scope of the present disclosure.

In the description of the present disclosure, it should be understood that orientations or position relationships indicated by the terms "center", "longitudinal", "lateral", "length", "width", "thickness", "upper", "lower", "front", "rear", "left", "right", "vertical", "horizontal", "top", "bottom", "inside", and "outside" are based on orientations or position relationships illustrated in the drawings. The terms are used to facilitate and simplify the description of the present disclosure, rather than indicate or imply that the devices or elements referred to herein are required to have specific orientations or be constructed or operate in the specific orientations. Accordingly, the terms should not be construed as limiting the present disclosure. In addition, the term "first", "second" are for illustrative purposes only and are not to be construed as indicating or imposing a relative importance or implicitly indicating the number of technical features indicated. Thus, a feature that limited by "first", "second" may expressly or implicitly include at least one of the features. In the description of the present disclosure, the meaning of "plurality" is two or more, unless otherwise specifically defined.

In the present disclosure, the word "exemplary" is used to mean "serving as an example, illustration, or explanation". Any embodiment described as "exemplary" in the present disclosure is not necessarily construed as being more preferable or advantageous than other embodiments. In order to enable any person skilled in the art to implement and use the present disclosure, the following description is given. In the following description, the details are listed for the purpose of explanation. It should be understood that those of ordinary skill in the art can realize that the present disclosure can also be implemented without using these specific details. In other instances, well-known structures and processes will not be elaborated to avoid unnecessary details to obscure the description of the present disclosure. Therefore, the present disclosure is not intended to be limited to the illustrated embodiments, but is consistent with the widest scope that conforms to the principles and features disclosed in the embodiments of the present disclosure.

Embodiments of the present disclosure provide a method and apparatus for determining a protection strategy for an energy storage system, and a device related thereto, which are described in detail below.

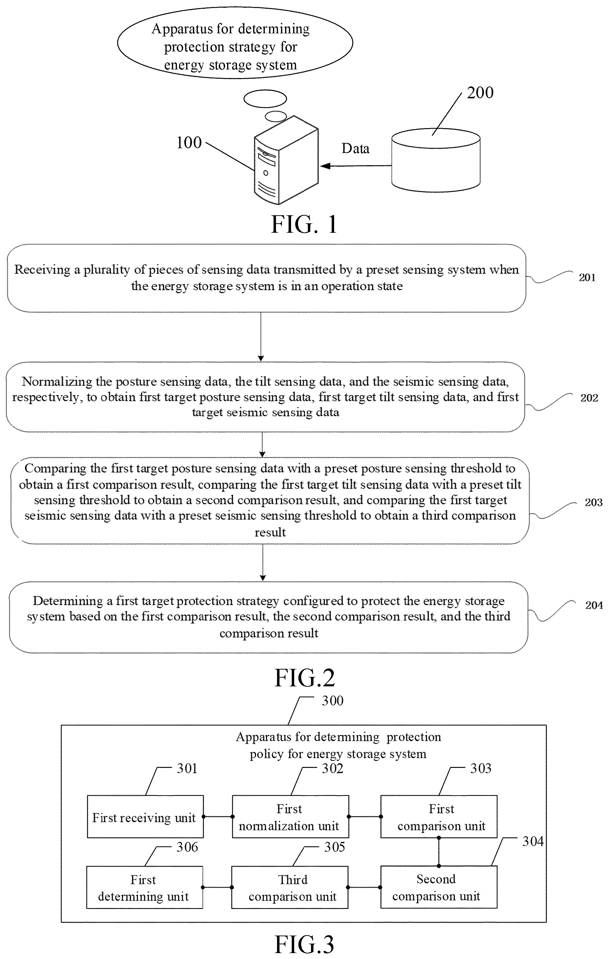

As shown in FIG. 1, which is a schematic diagram of a scenario of a system for determining a protection strategy for an energy storage system according to an embodiment of the present disclosure. The system for determining the protection strategy for the energy storage system may include an electronic device 100 in which an apparatus for determining a protection strategy for an energy storage system is integrated, such as the electronic device 100 shown in FIG. 1.

The electronic device 100 in the embodiment of the present disclosure is mainly configured to receive a plurality of pieces of sensing data transmitted by a preset sensing system when the energy storage system is in an operation state, the plurality of pieces of sensing data including posture sensing data, tilt sensing data, and seismic sensing data; normalize the posture sensing data, the tilt sensing data, and the seismic sensing data, respectively, to obtain first target posture sensing data, first target tilt sensing data, and first target seismic sensing data; compare the first target posture sensing data with a preset posture sensing threshold to obtain a first comparison result, compare the first target tilt sensing data with a preset tilt sensing threshold to obtain a second comparison result, and compare the first target seismic sensing data with a preset seismic sensing threshold to obtain a third comparison result; and determine a first target protection strategy configured to protect the energy storage system based on the first comparison result, the second comparison result, and the third comparison result.

In the embodiment of the present disclosure, the electronic device 100 may be a terminal or a server. When the electronic device 100 is the server, the electronic device 100 may be a stand-alone server, or may be a server network or a server cluster composed of servers. For example, the electronic device 100 described in the embodiment of the present disclosure includes, but is not limited to, a computer, a network host, a single network server, a plurality of network server clusters, or a cloud server composed of a plurality of servers. The cloud server is composed of a supercomputer based on cloud computing or a network server.

It should be understood that, when the electronic device 100 used in the embodiment of the present disclosure is a terminal, the used terminal may be a device including both receiving and transmitting hardware, i.e., a device having receiving and transmitting hardware capable of performing bidirectional communication over a bidirectional communication link. Such a device may include a cellular or other communication device having a single-line display or a multi-line display, or a cellular or other communication device without a multi-line display. Specifically, a specific electronic device 100 may be a desktop terminal or a mobile terminal. Specifically, the electronic device 100 may be one of a mobile phone, a tablet computer, a notebook computer, a medical auxiliary instrument, or the like.

It should be understood by those skilled in the art that an application environment shown in FIG. 1 is merely an application scenario of the solution of the present disclosure, and does not constitute a limitation on the application scenario of the solution of the present disclosure. Other application environments may also include more or fewer electronic devices than those shown in FIG. 1. For example, one electronic device is shown in FIG. 1. It should be understood that the system for determining the protection strategy for the energy storage system may also include one or more other electronic devices, which are not specifically limited herein.

In addition, as shown in FIG. 1, the system for determining the protection strategy for the energy storage system may further include a memory 200 configured to store data, for example, a plurality of pieces of sensing data transmitted by a sensing system and data for determining a protection policy for an energy storage system, such as data for determining a protection policy for an energy storage system when the system for determining the protection strategy for the energy storage system is running.

It should be noted that the schematic diagram of the scenario of the system for determining the protection strategy for the energy storage system shown in FIG. 1 is merely an example. The system for determining the protection strategy for the energy storage system and scenario described in the embodiments of the present disclosure are intended to more clearly illustrate the technical solution of the embodiments of the present disclosure, and do not constitute a limitation on the technical solution provided in the embodiments of the present disclosure. It will be appreciated by a person skilled in the art that the technical solution provided in the embodiments of the present disclosure is also applicable to similar technical problems with the evolution of the system for determining the protection strategy for the energy storage system and the emergence of a new service scenario.

Next, a method for determining a protection strategy for an energy storage system according to an embodiment of the present disclosure is described.

In an embodiment of the method for determining the protection strategy for the energy storage system of the embodiment of the present disclosure, an apparatus for determining a protection strategy for an energy storage system is used as an execution body. For simplicity and convenience of description, the execution body is omitted in a subsequent method embodiment, and the apparatus for determining the protection strategy for the energy storage system is applied to the electronic device. The method includes: receiving a plurality of pieces of sensing data transmitted by a preset sensing system when the energy storage system is in an operation state, the plurality of pieces of sensing data including posture sensing data, tilt sensing data, and seismic sensing data; normalizing the posture sensing data, the tilt sensing data, and the seismic sensing data, respectively, to obtain first target posture sensing data, first target tilt sensing data, and first target seismic sensing data; comparing the first target posture sensing data with a preset posture sensing threshold to obtain a first comparison result, comparing the first target tilt sensing data with a preset tilt sensing threshold to obtain a second comparison result, and comparing the first target seismic sensing data with a preset seismic sensing threshold to obtain a third comparison result; and determining a first target protection strategy configured to protect the energy storage system based on the first comparison result, the second comparison result, and the third comparison result.

Referring to FIGS. 2 to 4, FIG. 2 is a schematic flowchart of an embodiment of a method for determining a protection strategy for an energy storage system according to an embodiment of the present disclosure. The method for determining the protection strategy for the energy storage system includes following steps 201 to 204.

At step 201, a plurality of pieces of sensing data transmitted by a preset sensing system are received when the energy storage system is in an operation state.

The plurality of pieces of sensing data include posture sensing data, tilt sensing data, and seismic sensing data. The sensing system may be comprised of a plurality of sensors each configured to acquire corresponding sensing data. Specifically, the sensing system may include a posture sensor, a tilt sensor, and a seismic sensor, where the posture sensor may be configured to acquire posture sensing data of the energy storage system. Illustratively, the posture sensor may be a high-performance three-dimensional motion posture measurement system based on MEMS technology. The posture sensor may include motion sensors such as three-axis gyroscopes, three-axis accelerometers, three-axis electronic compasses, and the like, and obtain data such as three-dimensional posture and orientation after temperature compensation on the data is performed by an embedded low-power ARM processor. Zero-drift three-dimensional posture and orientation data represented by quaternions and Euler angles is outputted in real time using a quaternion-based three-dimensional algorithm and a special data fusion technique. The tilt sensor may be configured to acquire tilt sensing data of an energy storage system. The tilt sensor is also referred to as a tilt meter, an inclinometer, a level meter, a tilt meter, and often configured to measure change in a horizontal angle of the system. The level meter is a result of development of automation and electronic measurement techniques from a simple bubble level meter in the past to an electronic level meter in the present, and the tilt sensor may be used to measure change in a tilt angle with respect to a horizontal plane. The theoretical basis is Newton's second law. According to the basic physical principle, a velocity cannot be measured inside a system, but an acceleration can be measured. If an initial velocity is known, a linear velocity can be calculated by integration, and a linear displacement can be calculated. The seismic sensor may be configured to acquire seismic sensing data of the energy storage system. The seismic sensor is generally divided into three dimensions: East and West, North and South, and Vertical, and can monitor seismic signals. When an earthquake occurs, seismic waves are transmitted to the seismic sensor at a speed of 5 to 7 km per second. Next, the seismic sensor converts a detected mechanical signal into an electrical signal, thereby enabling the acquisition of seismic sensing data.

At step 202, the posture sensing data, the tilt sensing data, and the seismic sensing data are normalized respectively, to obtain first target posture sensing data, first target tilt sensing data, and first target seismic sensing data.

The normalization is mainly to convert (or map) the plurality of pieces of sensor data to a fractional number between (0,1), and is mainly proposed for convenience of data processing, so that the data is mapped into the range of 0~1 for processing, which is more convenient and fast.

At step 203, the first target posture sensing data is compared with a preset posture sensing threshold to obtain a first comparison result, the first target tilt sensing data is compared with a preset tilt sensing threshold to obtain a second comparison result, and the first target seismic sensing data is compared with a preset seismic sensing threshold to obtain a third comparison result.

The preset posture sensing threshold, the tilt sensing threshold, and the seismic sensing threshold may be adjusted according to actual requirements. Specifically, the comparison method is to compare each of target sensing data with a threshold corresponding thereto, and the comparison result may be the target sensing data is greater than, less than, or equal to the corresponding threshold.

At step 204, a first target protection strategy configured to protect the energy storage system is determined based on the first comparison result, the second comparison result, and the third comparison result.

Illustratively, how to determine the first target protection strategy configured to protect the energy storage system based on the first comparison result, the second comparison result, and the third comparison result may be implemented by following solution. The solution may specifically include following step A1 and step A2.

At step A1, a first risk level parameter of the energy storage system is determined based on the first comparison result, the second comparison result, and the third comparison result.

Illustratively, how to determine a first risk level parameter of the energy storage system based on the first comparison result, the second comparison result, and the third comparison result may be specifically implemented by following step F1.

At step F1, a first risk level parameter of the energy storage system is obtained by performing a weighted fit to the first comparison result, the second comparison result, and the third comparison result.

At step A2, the first target protection strategy configured to protect the energy storage system is determined based on the first risk level parameter and a preset set of risk level thresholds.

The set of risk level thresholds may include a first risk level threshold and a second risk level threshold. Illustratively, how to determine a first target protection strategy configured to protect the energy storage system based on the first risk level parameter and a preset set of risk level thresholds may be implemented by following solution. The solution may specifically include following steps B1 to B3.

At step B1, a preset first protection policy is called and used as the first target protection policy if the first risk level parameter is less than the first risk level threshold.

If the first risk level parameter is less than the first risk level threshold, it can be determined that an abnormal situation detected by the sensing system does not affect an operation of the energy storage system. Therefore, the first protection strategy can be configured to not interfere with an operation state of the energy storage system according to the determined situation. That is, it is ensured that the energy storage system can operate normally.

At step B2, a preset second protection policy is called and used as the first target protection policy if the first risk level parameter is less than the second risk level threshold and greater than or equal to the first risk level threshold.

If the first risk level parameter is less than the second risk level threshold value and greater than or equal to the first risk level threshold, it can be determined that the abnormal situation detected by the sensing system may affect a normal operation state of the energy storage system to a certain extent. Therefore, the second protection strategy can be configured to temporarily perform a power reduction operation according to the determined situation, and the first protection strategy can be restored to the normal operation state of the energy storage system once the abnormal situation is relieved.

At step B3, a preset third protection policy is called and used as the first target protection policy if the first risk level parameter is greater than the second risk level threshold.

If the first risk level parameter is greater than the second risk level threshold, it can be determined that the abnormal situation detected by the sensing system seriously affects the operation of the energy storage system. Therefore, the third protection strategy can be configured to immediately transmit an instruction to stop the operation of the energy storage system and cut off the connection between the energy storage system and a grid according to the determined situation.

The method may further include: after the step B3,
step C1 of receiving a plurality of pieces of sensing data transmitted by the sensing system again after a preset first time period, the plurality of pieces of sensing data comprising posture sensing data, tilt sensing data, and seismic sensing data;
step C2 of normalizing the posture sensing data, the tilt sensing data, and the seismic sensing data, respectively, to obtain second target posture sensing data, second target tilt sensing data, and second target seismic sensing data;
step C3 of comparing the second target posture sensing data with a preset posture sensing threshold to obtain a fourth comparison result, comparing the second target tilt sensing data with a preset tilt sensing threshold to obtain a fifth comparison result, and comparing the second target seismic sensing data with a preset seismic sensing threshold to obtain a sixth comparison result; and
step C4 of determining a second target protection strategy configured to control whether the energy storage system is turned on based on the fourth comparison result, the fifth comparison result, and the sixth comparison result.

The normalization in the step C2 is the same as that in the step 202, which is not repeated described herein. Similarly, the comparison in the step C3 is the same as that in the step 203, which is not repeated described herein.

The step C4 is implemented by using the steps A1 and A2. Each of the fourth comparison result, the fifth comparison result, and the sixth comparison result may be weighted summed to obtain corresponding second risk level parameter, and then the second risk level parameter is compared with a preset first risk level threshold value and a preset second risk level threshold, and then according to the comparison result, it is determined whether an abnormal situation is recovered. If the abnormal situation is recovered, the second target protection strategy is used to control the energy storage system to be automatically turned on again, otherwise, the energy storage system is not turned on.

The method for determining the protection strategy for the energy storage system provided in the present disclosure receives a plurality of pieces of sensing data transmitted by a preset sensing system when the energy storage system is in an operation state, the plurality of pieces of sensing data including posture sensing data, tilt sensing data, and seismic sensing data; normalizes the posture sensing data, the tilt sensing data, and the seismic sensing data, respectively, to obtain first target posture sensing data, first target tilt sensing data, and first target seismic sensing data; compares the first target posture sensing data with a preset posture sensing threshold to obtain a first comparison result, compares the first target tilt sensing data with a preset tilt sensing threshold to obtain a second comparison result, and compares the first target seismic sensing data with a preset seismic sensing threshold to obtain a third comparison result; and determines a first target protection strategy configured to protect the energy storage system based on the first comparison result, the second comparison result, and the third comparison result. It is possible to enable the energy storage system to actively cope with the ground fluctuating and bumping state (such as that caused by the earthquake or other factors) and the like that endangers the safety of the energy storage system, thereby improving the safety of the energy storage system.

In another embodiment of the present disclosure, the method may further include: after the step 204,
step D1 of receiving, in real time, a temperature sensing parameter transmitted by a preset temperature sensor; and
step D2 of determining a third target protection strategy configured for the energy storage system based on the temperature sensing parameter and a preset temperature threshold.

Illustratively, in some embodiments of the present disclosure, how to determine a third target protection strategy configured for the energy storage system based on the temperature sensing parameter and a preset temperature threshold may be specifically implemented by following solution, which may specifically include following steps E1 and E2.

At step E1, if the temperature sensing parameter is greater than or equal to the preset temperature threshold, a preset fourth protection policy is called and used as the third target protection policy.

The fourth protection policy is to cool the energy storage system.

At step E2, if the temperature sensing parameter is less than the preset temperature threshold, a preset fifth protection policy is called and used as the third target protection policy.

The fifth protection strategy may be to continue detecting the temperature sensing parameter.

According to the embodiment of the present disclosure, by detecting the temperature of the energy storage system, it is ensured that further faults such as self-ignition occur in the energy storage system, thereby further improving the safety of the energy storage system.

In order to better implement the method for determining the protection policy for the energy storage system in the embodiment of the present disclosure, the embodiment of the present disclosure further provides an apparatus for determining a protection policy for an energy storage system on the basis of the method for determining the protection policy for the energy storage system. As shown in FIG. 3, the apparatus for determining the protection policy for the energy storage system 300 includes:
a first receiving unit 301 configured to receive a plurality of pieces of sensing data transmitted by a preset sensing system when the energy storage system is in an operation state, the plurality of pieces of sensing data including posture sensing data, tilt sensing data, and seismic sensing data;
a first normalization unit 302 configured to normalize the posture sensing data, the tilt sensing data, and the seismic sensing data, respectively, to obtain first target posture sensing data, first target tilt sensing data, and first target seismic sensing data;
a first comparison unit 303 configured to compare the first target posture sensing data with a preset posture sensing threshold to obtain a first comparison result, a second comparison unit 304 configured to compare the first target tilt sensing data with a preset tilt sensing threshold to obtain a second comparison result, and a third comparison unit 305 configured to compare the first target seismic sensing data with a preset seismic sensing threshold to obtain a third comparison result; and
a first determining unit 306 configured to determine a first target protection strategy configured to protect the energy storage system based on the first comparison result, the second comparison result, and the third comparison result.

In a possible implementation of the present disclosure, the first determining unit 306 specifically includes:
a second determining unit configured to determine a first risk level parameter of the energy storage system based on the first comparison result, the second comparison result, and the third comparison result; and
a third determining unit configured to determine the first target protection strategy configured to protect the energy storage system based on the first risk level parameter and a preset set of risk level thresholds.

In a possible implementation of the present disclosure, the set of risk level thresholds includes a first risk level threshold and a second risk level threshold.

The third determining unit is specifically configured to:
call and use a preset first protection policy as the first target protection policy if the first risk level parameter is less than the first risk level threshold;
call and use a preset second protection policy as the first target protection policy if the first risk level parameter is less than the second risk level threshold and greater than or equal to the first risk level threshold; and
call and use a preset third protection policy as the first target protection policy if the first risk level parameter is greater than the second risk level threshold.

In a possible implementation of the present disclosure, the apparatus is configured to: after the calling and using of the preset third protection policy as the first target protection policy if the first risk level parameter is greater than the second risk level threshold,
receive a plurality of pieces of sensing data transmitted by the sensing system again after a preset first time period, the plurality of pieces of sensing data comprising posture sensing data, tilt sensing data, and seismic sensing data;
normalize the posture sensing data, the tilt sensing data, and the seismic sensing data, respectively, to obtain second target posture sensing data, second target tilt sensing data, and second target seismic sensing data;
compare the second target posture sensing data with a preset posture sensing threshold to obtain a fourth comparison result, compare the second target tilt sensing data with a preset tilt sensing threshold to obtain a fifth comparison result, and compare the second target seismic sensing data with a preset seismic sensing threshold to obtain a sixth comparison result; and
determine a second target protection strategy configured to control whether the energy storage system is turned on based on the fourth comparison result, the fifth comparison result, and the sixth comparison result.

In a possible implementation of the present disclosure, the second determining unit is specifically configured to:
obtain a first risk level parameter of the energy storage system by performing a weighted fit to the first comparison result, the second comparison result, and the third comparison result.

In a possible implementation of the present disclosure, the apparatus further includes: after determining of the first target protection strategy configured to protect the energy storage system based on the first comparison result, the second comparison result, and the third comparison result,
a second receiving unit configured to receive, in real time, a temperature sensing parameter transmitted by a preset temperature sensor; and
a fourth determining unit configured to determine the first target protection strategy configured to protect the energy storage system based on the first risk level parameter and a preset set of risk level thresholds.

In a possible implementation of the present disclosure, the fourth determining unit is specifically configured to:
call and use a preset fourth protection policy as the third target protection policy if the temperature sensing parameter is greater than or equal to the preset temperature threshold; and
call and use a preset fifth protection policy as the third target protection policy if the temperature sensing parameter is less than the preset temperature threshold.

In the apparatus for determining the protection strategy for the energy storage system provided in the present disclosure, the first receiving unit 301 is configured to receive a plurality of pieces of sensing data transmitted by a preset sensing system when the energy storage system is in an operation state, the plurality of pieces of sensing data including posture sensing data, tilt sensing data, and seismic sensing data; the first normalization unit 302 is configured to normalize the posture sensing data, the tilt sensing data, and the seismic sensing data, respectively, to obtain first target posture sensing data, first target tilt sensing data, and first target seismic sensing data; the first comparison unit 303 is configured to compare the first target posture sensing data with a preset posture sensing threshold to obtain a first comparison result, the second comparison unit 304 is configured to compare the first target tilt sensing data with a preset tilt sensing threshold to obtain a second comparison result, and the third comparison unit 305 is configured to compare the first target seismic sensing data with a preset seismic sensing threshold to obtain a third comparison result; and the first determining unit 306 is configured to determine a first target protection strategy configured to protect the energy storage system based on the first comparison result, the second comparison result, and the third comparison result. It is possible to enable the energy storage system to actively cope with the ground fluctuating and bumping state (such as that caused by the earthquake or other factors) and the like that endangers the safety of the energy storage system, thereby improving the safety of the energy storage system.

In addition to the above-described method and apparatus for determining the protection strategy for the energy storage system, another embodiment of the present disclosure further provides an electronic device that integrates the apparatus for determining the protection strategy for the energy storage system provided in any of embodiments of the present disclosure, where the electronic device includes:
one or more processors;
a memory; and
one or more application programs, where the one or more application programs are stored in the memory and configured to be executed by the processors to implement any of the methods for determining the protection strategy for the energy storage system as described in the above embodiments.

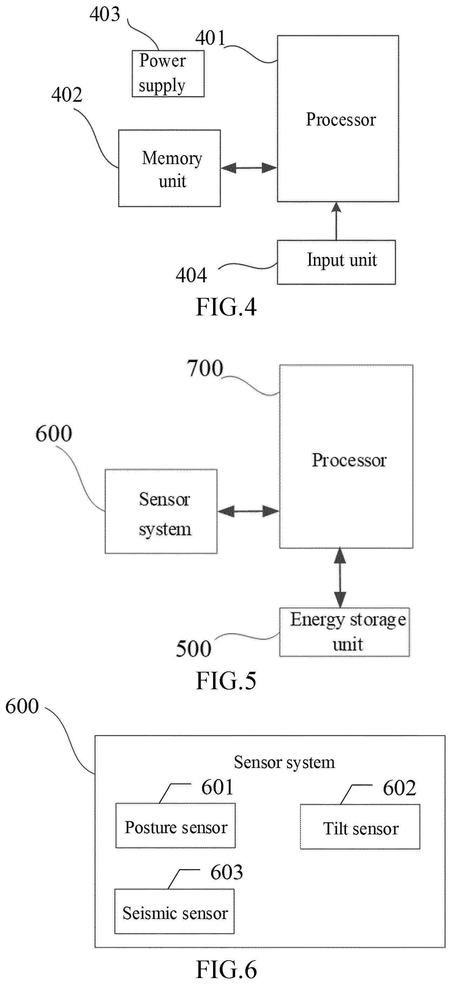

Yet another embodiment of the present disclosure further provides an electronic device that integrates any of the apparatuses for determining the protection strategy for the energy storage system provided by the embodiments of the present disclosure. As shown in FIG. 4, which shows a schematic structural diagram of the electronic device according to an embodiment of the present disclosure.

Specifically, the electronic device may include components such as a processor 401 of one or more processing cores, a memory unit 402 of one or more computer-readable storage media, a power supply 403, and an input unit 404, where the computer-readable storage media may be non-volatile or volatile. It should be understood by those skilled in the art that the structure of the electronic device shown in FIG. 4 should be not constituted to be a limitation on the electronic device, and may include more or less components than illustrated, or may combine certain components, or different component arrangements. Where:
the processor 401 is a control center of the electronic device. The processor 401 is connected to various parts of the entire electronic device by various interfaces and lines, and performs various functions of the electronic device and processes data by running or executing software programs and/or modules stored in the memory unit 402 and invoking data stored in the memory unit 402, thereby monitoring the electronic device as a whole. Alternatively, the processor 401 may include one or more processing cores. Alternatively, the processor 401 may integrate an application processor and a modem processor, where the application processor mainly processes an operating system, a user interface, an application program, and the like, and the modem processor mainly processes wireless communication. It should be understood that the modulation/demodulation processor can be independent from the processor 401.

The memory unit 402 may be used to store software programs and modules, and the processor 401 executes various functional applications and data processing by running the software programs and modules stored in the memory unit 402. The memory unit 402 may mainly include a storage program area and a storage data area, where the storage program area may store an operating system, an application program (such as a sound play function, an image play function, and the like) required by at least one function, and the like; and the storage data area may store data or the like created according to the use of the electronic device. In addition, the memory unit 402 may include a high speed random access memory, and may also include a non-volatile memory, such as at least one magnetic disk storage device, a flash memory device, or other volatile solid state storage device. Accordingly, the memory unit 402 may further include a memory controller to provide access to the memory unit 402 by the processor 401.

The electronic device further includes a power supply 403 for supplying power to the respective components. Alternatively, the power supply 403 may be logically connected to the processor 401 by the power supply management system, so that functions such as charging, discharging, and power consumption management are managed by the power supply management system. The power supply 403 may further include one or more direct current (DC)/or alternating current (AC) power sources, recharging system, power failure detection circuit, power converter or inverter, power supply status indicator, and the like.

The electronic device may also include an input unit 404 operable to receive input numeric or character information and to generate a signal input of a keyboard, a mouse, a joystick, an optical or a trackball related to user settings and functional control.

Although not shown, the electronic device may also include a display unit or the like, of which details are not repeatedly described herein. In the embodiment of the present disclosure, the processor 401 in the electronic device may load executable files corresponding to processes of one or more application programs into the memory unit 402 according to the following instructions, and the processor 401 executes the application programs stored in the memory unit 402 to implement various functions including:
receiving a plurality of pieces of sensing data transmitted by a preset sensing system when the energy storage system is in an operation state, the plurality of pieces of sensing data including posture sensing data, tilt sensing data, and seismic sensing data; normalizing the posture sensing data, the tilt sensing data, and the seismic sensing data, respectively, to obtain first target posture sensing data, first target tilt sensing data, and first target seismic sensing data; comparing the first target posture sensing data with a preset posture sensing threshold to obtain a first comparison result, comparing the first target tilt sensing data with a preset tilt sensing threshold to obtain a second comparison result, and comparing the first target seismic sensing data with a preset seismic sensing threshold to obtain a third comparison result; and determining a first target protection strategy configured to protect the energy storage system based on the first comparison result, the second comparison result, and the third comparison result.

The method for determining the protection strategy for the energy storage system provided in the present disclosure receives a plurality of pieces of sensing data transmitted by a preset sensing system when the energy storage system is in an operation state, the plurality of pieces of sensing data including posture sensing data, tilt sensing data, and seismic sensing data; normalizes the posture sensing data, the tilt sensing data, and the seismic sensing data, respectively, to obtain first target posture sensing data, first target tilt sensing data, and first target seismic sensing data; compares the first target posture sensing data with a preset posture sensing threshold to obtain a first comparison result, compares the first target tilt sensing data with a preset tilt sensing threshold to obtain a second comparison result, and compares the first target seismic sensing data with a preset seismic sensing threshold to obtain a third comparison result; and determines a first target protection strategy configured to protect the energy storage system based on the first comparison result, the second comparison result, and the third comparison result. It is possible to enable the energy storage system to actively cope with the ground fluctuating and bumping state (such as that caused by the earthquake or other factors) and the like that endangers the safety of the energy storage system, thereby improving the safety of the energy storage system.

To this end, yet another embodiment of the present disclosure further provides a computer readable storage medium. The computer readable storage medium may include a Read Only Memory (ROM), a Random Access Memory (RAM), a magnetic disk, an optical disk, or the like. The computer readable storage medium is stored with a plurality of instructions that can be loaded by the processor to execute the steps of any of the methods for determining the protection strategy for the energy storage system provided in the embodiments of the present disclosure. For example, the program instructions can perform following operations including:
receiving a plurality of pieces of sensing data transmitted by a preset sensing system when the energy storage system is in an operation state, the plurality of pieces of sensing data including posture sensing data, tilt sensing data, and seismic sensing data; normalizing the posture sensing data, the tilt sensing data, and the seismic sensing data, respectively, to obtain first target posture sensing data, first target tilt sensing data, and first target seismic sensing data; comparing the first target posture sensing data with a preset posture sensing threshold to obtain a first comparison result, comparing the first target tilt sensing data with a preset tilt sensing threshold to obtain a second comparison result, and comparing the first target seismic sensing data with a preset seismic sensing threshold to obtain a third comparison result; and determining a first target protection strategy configured to protect the energy storage system based on the first comparison result, the second comparison result, and the third comparison result.

Further, yet another embodiment of the present disclosure provides an energy storage management and protection system, including: an energy storage unit; a sensor system including at least a posture sensor, a tilt sensor, and a seismic sensor, the sensor system being configured to respectively acquire a plurality of pieces of sensing data of the energy storage unit in an operation state; and a processor electrically connected to the energy storage unit and the sensor system, respectively, the processor being configured to receive the plurality of pieces of sensing data transmitted by the sensor system, determine a target protection policy for protecting the energy storage unit, and control the operation state of the energy storage unit based on the target protection policy.

Please refer to FIGS. 5 and 6, FIG. 5 is a schematic structural diagram of an embodiment of an energy storage management and protection system according to an embodiment of the present disclosure. The energy storage management and protection system includes:
an energy storage unit 500; a sensor system 600 including at least a posture sensor 601, a tilt sensor 602, and a seismic sensor 603, the sensor system 600 being configured to respectively acquire a plurality of pieces of sensing data of the energy storage unit 500 in an operation state. Where the posture sensor 601 may be used to acquire the posture sensing data of the energy storage system. Illustratively, the posture sensor 601 may be a high-performance three-dimensional motion posture measurement system based on MEMS technology. The posture sensor may include motion sensors such as three-axis gyroscopes, three-axis accelerometers, three-axis electronic compasses, and the like, and obtain data such as three-dimensional posture and orientation after temperature compensation on the data is performed by an embedded low-power ARM processor 700. Zero-drift three-dimensional posture and orientation data represented by quaternions and Euler angles is outputted in real time using a quaternion-based three-dimensional algorithm and a special data fusion technique. The tilt sensor 602 may be configured to acquire tilt sensing data of an energy storage system. The tilt sensor 602 is also referred to as a tilt meter, a inclinometer, a level meter, a tilt meter, and often configured to measure change in a horizontal angle of the system. The level meter is a result of development of automation and electronic measurement techniques from a simple bubble level meter in the past to an electronic level meter in the present, and the tilt sensor 602 may be used to measure change in a tilt angle with respect to a horizontal plane. The theoretical basis is Newton's second law. According to the basic physical principle, a velocity cannot be measured inside a system, but an acceleration can be measured. If an initial velocity is known, a linear velocity can be calculated by integration, and a linear displacement can be calculated. The seismic sensor 603 may be configured to acquire seismic sensing data of the energy storage system. The seismic sensor 603 is generally divided into three dimensions: East and West, North and South, and Vertical, and can monitor seismic signals. When an earthquake occurs, seismic waves are transmitted to the seismic sensor 603 at a speed of 5 to 7 km per second. Next, the seismic sensor 603 may convert a detected mechanical signal into an electrical signal, thereby enabling the acquisition of seismic sensing data. The energy storage management and protection system further includes a processor 700 electrically connected to the energy storage unit 500 and the sensor system 600, respectively, the processor 700 being configured to receive the plurality of pieces of sensing data transmitted by the sensor system 600, determine a target protection policy for protecting the energy storage unit 500, and control the operation state of the energy storage unit 500 based on the target protection policy. The sensors in the sensor system 600 are all electrically connected to the processor 700.

After receiving the plurality of pieces of sensing data transmitted by the sensor system 600, the processor 700 may normalize the posture sensing data, the tilt sensing data, and the seismic sensing data to obtain the first target posture sensing data, the first target tilt sensing data, and the first target seismic sensing data, where the normalization is mainly to convert (or map) the plurality of pieces of sensor data to a fractional number between (0,1), and is mainly proposed for convenience of data processing, so that the data is mapped into the range of 0~1 for processing, which is more convenient and fast. Then, the first target posture sensing data is compared with a preset posture sensing threshold to obtain a first comparison result, the first target tilt sensing data is compared with a preset tilt sensing threshold to obtain a second comparison result, and the first target seismic sensing data is compared with a preset seismic sensing threshold to obtain a third comparison result. The preset posture sensing threshold, the tilt sensing threshold, and the seismic sensing threshold may be adjusted according to actual requirements. Specifically, the comparison method is to compare each of target sensing data with a threshold corresponding thereto, and the comparison result may be the target sensing data is greater than, less than, or equal to the corresponding threshold. Finally, a target protection strategy for protecting the energy storage system is determined based on the first comparison result, the second comparison result, and the third comparison result, where the target protection strategy may specifically include a first protection strategy, a second protection strategy, and a third protection strategy. According to the three comparison results, the present disclosure determines the severity of an abnormal situation, so as to select different protection strategies. Specifically, when it is determined that the abnormal situation detected by the sensor system does not affect the operation of the energy storage system, the first protection strategy may be configured, according to the determined situation, to not interfere with the operation state of the energy storage system, that is, to ensure that the energy storage system can operate normally. When it is determined that the abnormal situation detected by the sensor system may affect the normal operation state of the energy storage system to a certain extent, the second protection strategy may be configured to temporarily perform the power reduction operation according to the determined situation, and the energy storage system may be restored to the first protection strategy until the energy storage system operates normally once the abnormal situation is relieved; when it is determined that the abnormal situation detected by the sensor system seriously affects the operation of the energy storage system, the third protection strategy may be configured to immediately issue an instruction to stop the operation of the energy storage system and cut off the connection between the energy storage system and the grid according to the determined situation.

The sensor system 600 is provided in the energy storage management and protection system in the embodiment of the present disclosure, where the sensor system 600 includes at least a posture sensor 601, a tilt sensor 602, and a seismic sensor 603, and the sensor system 600 is configured to respectively acquire a plurality of pieces of sensing data of the energy storage unit 500 in an operation state; and then the processor receives the plurality of pieces of sensing data transmitted by the sensor system 600, determines a target protection policy for protecting the energy storage unit 500, and control the operation state of the energy storage unit 500 based on the target protection policy. As such, it is possible to enable the energy storage system to actively cope with the ground fluctuating and bumping state or even drastic fluctuating, thereby improving the safety of the energy storage system.

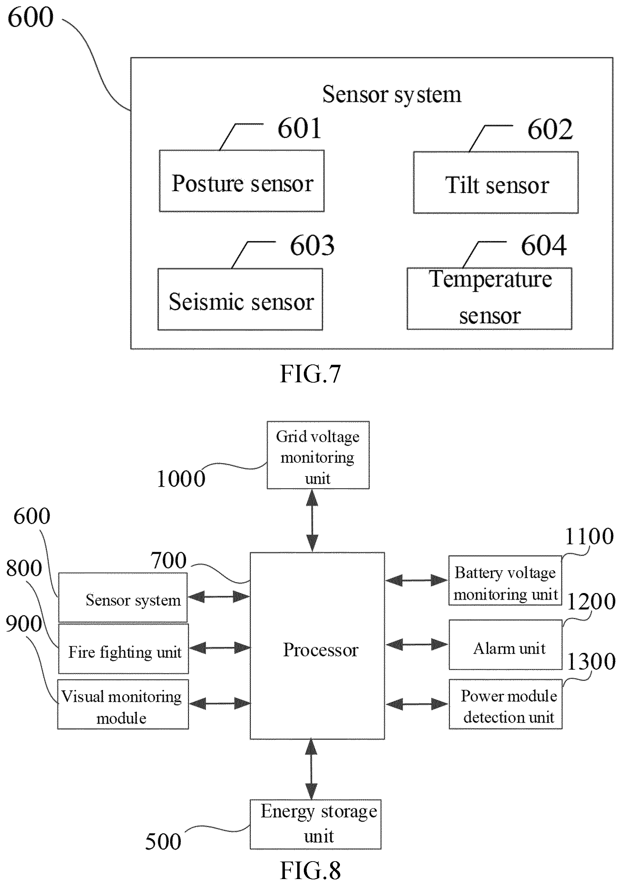

In some embodiments of the present disclosure, as shown in FIG. 7, the sensor system 600 further includes a temperature sensor 604 electrically connected to the processor 700 and configured to measure an ambient temperature of the energy storage unit 500 in real time. Specifically, the temperature sensor 604 may be used to measure the temperature of the energy storage unit 500 itself in real time in addition to measuring the ambient temperature of the energy storage unit 500 in real time.

The temperature sensor 604 (temperature transducer) is a sensor capable of sensing temperature and converting it into an available output signal. The temperature sensor 604 can be divided into a contact type and a non-contact type according to the measurement method. The temperature sensor 604 can be divided into a thermal resistor and a thermocouple according to the characteristics of the sensor material and the electronic components. The temperature sensor 604 for measuring the ambient temperature can be a non-contact type of temperature sensor 604, while the temperature sensor 604 for measuring the energy storage system can be a contact type of temperature sensor 604.

As shown in FIG. 8 below, in some embodiments of the present disclosure, the energy storage management and protection system further includes: a fire fighting unit 800 electrically connected to the processor 700 and configured to receive fire fighting execution information transmitted by the processor 700 and perform a fire fighting operation based on the fire fighting execution information.

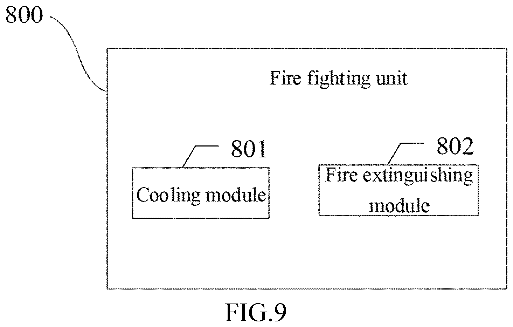

In some embodiments of the present disclosure, as shown in FIG. 9, the fire fighting unit 800 includes a cooling module 801 electrically connected to the processor 700 and configured to cool the energy storage unit 500. Specifically, the cooling module 801 may employ an air cooling module, which may be a refrigeration and air conditioning apparatus.

In some embodiments of the present disclosure, the energy storage management and protection system further includes a visual monitoring module 900 electrically connected to the processor 700 and configured to monitor an operation state and an operation environment of the energy storage unit 500, where the visual detection is to perform measurement and discrimination by a machine in place of a human eye. The visual detection refers to converting a captured object into an image signal by a machine vision product (i.e., an image capturing device, including CMOS and CCD), transmitting the image signal to a dedicated image processing system, and converting the image signal into a digitized signal according to information such as pixel distribution, brightness, and color; and performing various operations on these signals by an image system to extract the characteristics of the object, and then controlling an operation of a field device according to the result of the discrimination. Specifically, the present disclosure may detect whether there is an abnormality such as an open fire by the visual detection module.

Further, in some embodiments of the present disclosure, as shown in FIG. 9, when it is detected by the visual detection module that there is the open fire or the like in the energy storage system or near the energy storage system, the fire fighting unit 800 further includes a fire extinguishing module 802 for extinguishing the energy storage unit 500, where the fire extinguishing module 802 is mainly composed of a fire extinguisher (carbon dioxide extinguishing device), a digital temperature control alarm and a communication module. It is possible to remotely monitor and control real-time temperature change, alarm status and fire extinguisher information in a fire extinguishing region through the digital communication module in the device. It is possible not only to remotely monitor various status of an automatic fire extinguishing device, but also to master real-time change in the fire extinguishing region, so that the loss of life and property can be minimized when a fire occurs. Specifically, the fire extinguishing module 802 can be generally disposed above and around the energy storage system, and water cannot be used to extinguish the fire in consideration of the fire in the energy storage system. The fire extinguishing module 802 can be provided in other ways, such as powder spraying fire extinguishing device.

In some embodiments of the present disclosure, the energy storage management and protection system further includes: a grid voltage monitoring unit 1000 electrically connected to the processor 700 and configured to monitor voltage data and waveform data of the grid.

The grid voltage monitoring unit 1000 is configured to monitor voltage data and waveform data of the grid, and transmit the voltage data and the waveform data to the processor 700. After receiving the voltage data and the waveform data, the processor 700 compares the voltage data and the waveform data with preset voltage data threshold and preset waveform data threshold. If the voltage data and the waveform data exceed the preset voltage data threshold and the waveform data threshold, a grid alarm signal is generated and transmitted to an alarm unit 1200. After receiving the grid alarm signal, the alarm unit 1200 performs alarm.

In some embodiments of the present disclosure, the energy storage management and protection system further includes: a battery voltage monitoring unit 1100 electrically connected to the processor 700 and configured to monitor voltage data of the battery when the energy storage unit 500 is operated.

The battery voltage monitoring unit 1100 is configured to monitor voltage data of the battery when the battery is operated and transmit the voltage data to the processor 700. After receiving the voltage data, the processor 700 compares the voltage data with a preset voltage data threshold. If the voltage data exceeds a preset voltage data threshold, a voltage alarm signal is generated and transmitted to the alarm unit 1200. After receiving the grid alarm signal, the alarm unit 1200 performs alarm.

In some embodiments of the present disclosure, the energy storage management and protection system further includes: an alarm unit 1200 electrically connected to the processor 700 and configured to receive alarm information transmitted by the processor 700 to perform alarm.

In some embodiments of the present disclosure, the energy storage management and protection system further includes: a power module detection unit 1300 electrically connected to the processor 700 and configured to monitor power data of the energy storage unit 500 to determine whether the energy storage unit 500 is overloaded.

The power module detection unit 1300 is configured to monitor power data of the energy storage system to determine whether the energy storage system is overloaded, and transmit the power data to the processor 700. After receiving the power data, the processor 700 compares the power data with a preset power data threshold. If the power data exceeds the power data threshold, a power alarm signal is generated and transmitted to the alarm unit 1200. After receiving the grid alarm signal, the alarm unit 1200 performs alarm.

It should be noted that the processor 401 is the same as the processor 700.

In the foregoing embodiments, descriptions of the embodiments are emphasized. A portion that is not described in detail in an embodiment may refer to related descriptions in another embodiment.

The method and the apparatus for determining the protection strategy for the energy storage system and the device related thereto provided in the embodiments of the present disclosure are described in detail above. A specific example is used herein to describe a principle and an implementation of the present disclosure. The description of the foregoing embodiments is merely used to help understand a method and a core idea of the present disclosure. In addition, a person skilled in the art may make changes in a specific implementation manner and an application scope according to an idea of the present disclosure. In view of the foregoing, content of this specification should not be construed as a limitation on the present disclosure.

## Claims

1. A method for determining a protection strategy for an energy storage system, comprising:
receiving a plurality of pieces of sensing data transmitted by a preset sensing system when the energy storage system is in an operation state, the plurality of pieces of sensing data comprising posture sensing data, tilt sensing data, and seismic sensing data;
normalizing the posture sensing data, the tilt sensing data, and the seismic sensing data, respectively, to obtain first target posture sensing data, first target tilt sensing data, and first target seismic sensing data;
comparing the first target posture sensing data with a preset posture sensing threshold to obtain a first comparison result, comparing the first target tilt sensing data with a preset tilt sensing threshold to obtain a second comparison result, and comparing the first target seismic sensing data with a preset seismic sensing threshold to obtain a third comparison result; and
determining a first target protection strategy configured to protect the energy storage system based on the first comparison result, the second comparison result, and the third comparison result.

2. The method of claim 1, wherein the determining of the first target protection strategy comprises:
determining a first risk level parameter of the energy storage system based on the first comparison result, the second comparison result, and the third comparison result; and
determining the first target protection strategy configured to protect the energy storage system based on the first risk level parameter and a preset set of risk level thresholds.

3. The method of claim 2, wherein the set of risk level thresholds comprises a first risk level threshold and a second risk level threshold; and
wherein the determining of the first target protection strategy configured to protect the energy storage system based on the first risk level parameter and the preset set of risk level thresholds comprises:
calling and using a preset first protection policy as the first target protection policy in response to the first risk level parameter being less than the first risk level threshold;
calling and using a preset second protection policy as the first target protection policy in response to the first risk level parameter being less than the second risk level threshold and greater than or equal to the first risk level threshold; and
calling and using a preset third protection policy as the first target protection policy in response to the first risk level parameter being greater than the second risk level threshold.

4. The method of claim 3, further comprising: after the calling of the preset third protection policy in response to the first risk level parameter being greater than the second risk level threshold,
receiving a plurality of pieces of sensing data transmitted by the sensing system again after a preset first time period, the plurality of pieces of sensing data comprising posture sensing data, tilt sensing data, and seismic sensing data;
normalizing the posture sensing data, the tilt sensing data, and the seismic sensing data, respectively, to obtain second target posture sensing data, second target tilt sensing data, and second target seismic sensing data;
comparing the second target posture sensing data with the preset posture sensing threshold to obtain a fourth comparison result, comparing the second target tilt sensing data with the preset tilt sensing threshold to obtain a fifth comparison result, and comparing the second target seismic sensing data with the preset seismic sensing threshold to obtain a sixth comparison result; and
determining a second target protection strategy configured to control whether the energy storage system is turned on based on the fourth comparison result, the fifth comparison result, and the sixth comparison result.

5. The method of any one of claims 1-4, wherein the determining of the first risk level parameter of the energy storage system based on the first comparison result, the second comparison result, and the third comparison result comprises:
obtaining a first risk level parameter of the energy storage system by performing a weighted fit to the first comparison result, the second comparison result, and the third comparison result.

6. The method of any one of claims 1-4, further comprising: after the determining of the first target protection strategy configured to protect the energy storage system based on the first comparison result, the second comparison result, and the third comparison result,
receiving, in real time, a temperature sensing parameter transmitted by a preset temperature sensor; and
determining a third target protection strategy configured for the energy storage system based on the temperature sensing parameter and a preset temperature threshold.

7. The method of claim 6, wherein the determining of the third target protection strategy configured for the energy storage system based on the temperature sensing parameter and the preset temperature threshold comprises:
calling and using a preset fourth protection policy as the third target protection policy in response to the temperature sensing parameter being greater than or equal to the preset temperature threshold; and
calling and using a preset fifth protection policy as the third target protection policy in response to the temperature sensing parameter being less than the preset temperature threshold.

8. An apparatus for determining a protection strategy for an energy storage system, comprising:
a first receiving unit configured to receive a plurality of pieces of sensing data transmitted by a preset sensing system when the energy storage system is in an operation state, the plurality of pieces of sensing data including posture sensing data, tilt sensing data, and seismic sensing data;
a first normalization unit configured to normalize the posture sensing data, the tilt sensing data, and the seismic sensing data, respectively, to obtain first target posture sensing data, first target tilt sensing data, and first target seismic sensing data;
a first comparison unit configured to compare the first target posture sensing data with a preset posture sensing threshold to obtain a first comparison result, a second comparison unit configured to compare the first target tilt sensing data with a preset tilt sensing threshold to obtain a second comparison result, and a third comparison unit configured to compare the first target seismic sensing data with a preset seismic sensing threshold to obtain a third comparison result; and
a first determining unit configured to determine a first target protection strategy configured to protect the energy storage system based on the first comparison result, the second comparison result, and the third comparison result.

9. An electronic device, comprising:
one or more processors;
a memory; and
one or more application programs, wherein the one or more application programs are stored in the memory and configured to be executed by the processors to implement the method of any one of claims 1-7.

10. A computer readable storage medium having stored thereon a computer program that is loaded by a processor to perform steps of the method of any of claims 1-7.

11. An energy storage management and protection system, comprising:
an energy storage unit;
a sensor system comprising at least a posture sensor, a tilt sensor, and a seismic sensor and configured to acquire a plurality of pieces of sensing data of the energy storage unit in an operation state, respectively; and
a processor electrically connected to the energy storage unit and the sensor system, respectively, the processor being configured to receive the plurality of pieces of sensing data transmitted by the sensor system, determine a target protection policy for protecting the energy storage unit, and control the operation state of the energy storage unit based on the target protection policy.

12. The system of claim 11, wherein the sensor system further comprises: a temperature sensor electrically connected to the processor and configured to measure, in real time, an ambient temperature of the energy storage unit.

13. The system of claim 11, further comprising: a fire fighting unit electrically connected to the processor and configured to receive fire fighting execution information transmitted by the processor and perform a fire fighting operation based on the fire fighting execution information.

14. The system of claim 13, wherein the fire fighting unit comprises: a cooling module electrically connected to the processor and configured to cool the energy storage unit.

15. The system of claim 13, further comprising: a visual monitoring module electrically connected to the processor and configured to monitor an operation state and an operation environment of the energy storage unit.

16. The system of claim 13 or 15, wherein the fire fighting unit further comprises: a fire extinguishing module for extinguishing the energy storage unit.

17. The system of any one of claims 11-15, further comprising: a grid voltage monitoring unit electrically connected to the processor and configured to monitor voltage data and waveform data of the grid.

18. The system of any one of claims 11-15, further comprising: a battery voltage monitoring unit electrically connected to the processor and configured to monitor voltage data when the energy storage unit is operated.

19. The system of any one of claims 11-15, further comprising: an alarm unit electrically connected to the processor and configured to receive alarm information transmitted by the processor to perform alarm.

20. The system of any one of claims 11-15, further comprising: a power module detection unit electrically connected to the processor and configured to monitor power data of the energy storage unit to determine whether the energy storage unit is overloaded.
